# EUROPÄISCHE PATENTANMELDUNG

(11) **EP 4 199 074 A1**
(43) Veröffentlichungstag der Anmeldung: **21.06.2023**
(21) Anmeldenummer: 21215158.3
(22) Anmeldetag: 16.12.2021
(51) Int. Cl.: H01L 23/427

(54) **ELEKTRONIKMODUL UMFASSEND EINE PULSIERENDE HEATPIPE MIT EINER KANALSTRUKTUR**

(71) Anmelder: Siemens Aktiengesellschaft, 80333 München (DE)
(72) Erfinder: Danov, Vladimir, 91056 Erlangen (DE); Pfefferlein, Stefan, 90562 Heroldsberg (DE); Schwarz, Florian, 90766 Fürth (DE); Stegmeier, Stefan, 81825 München (DE)
(74) Vertreter: Siemens Patent Attorneys

(57) **Zusammenfassung**

Die Erfindung betrifft ein Elektronikmodul (2), umfassend eine pulsierende Heatpipe (4) mit einer Kanalstruktur (14), in der ein Wärmetransportmedium (16) angeordnet ist, und zumindest ein elektronisches Bauelement (6), das mit dem Wärmetransportmedium (16) in einer thermisch leitfähigen Verbindung steht. Um, im Vergleich zum Stand der Technik, eine bessere Kostenposition zu erreichen, wird vorgeschlagen, dass die pulsierende Heatpipe (4) wenigstens einen Grundkörper (12) aufweist, in welchem die Kanalstruktur (14) zumindest teilweise ausgebildet ist, wobei der Grundkörper (12) aus einem dielektrischen Werkstoff hergestellt und zumindest teilweise fluiddicht beschichtet ist, wobei das zumindest ein elektronisches Bauelement (6) über die pulsierende Heatpipe (4) mit einer metallischen Wärmesenke (10) elektrisch isolierend und thermisch leitend verbunden ist.

## Beschreibung

Die Erfindung betrifft ein Elektronikmodul, umfassend eine pulsierende Heatpipe mit einer Kanalstruktur, in der ein Wärmetransportmedium angeordnet ist, und zumindest ein elektronisches Bauelement, das mit dem Wärmetransportmedium in einer thermisch leitfähigen Verbindung steht.

Ferner betrifft die Erfindung einen Stromrichter mit mindestens einem derartigen Elektronikmodul.

Darüber hinaus betrifft die Erfindung ein Verfahren zur Herstellung eines Elektronikmoduls, umfassend eine pulsierende Heatpipe mit einer Kanalstruktur, in der ein Wärmetransportmedium angeordnet wird, und zumindest ein elektronisches Bauelement, das mit dem Wärmetransportmedium in einer thermisch leitfähigen Verbindung steht.

Derartige Elektronikmodule kommen beispielsweise in einem Stromrichter zum Einsatz und können aktive und/oder passive elektronische Bauelemente umfassen. Ein Elektronikmodul kann unter anderem ein Leistungshalbleitermodul, ein Modul für digitale Signalverarbeitung aber auch ein Shunt-Modul sein. Unter einem Stromrichter ist beispielsweise ein Gleichrichter, ein Wechselrichter, ein Umrichter oder ein Gleichspannungswandler zu verstehen.

Mit der fortschreitenden Miniaturisierung in der Aufbau- und Verbindungstechnik, beispielsweise durch eine planare Aufbau- und Verbindungstechnik, nimmt die Leistungsdichte in Elektronikmodulen zu. Um Elektronikausfälle durch thermische Überlastungen zu vermeiden, kommt beispielsweise eine pulsierende Heatpipe (engl. pulsating heat pipe, PHP), welche auch als oszillierende Heatpipe (engl. oscillating heat pipe, OHP) bezeichnet wird, zum Einsatz. Eine pulsierende Heatpipe ist eine Vorrichtung zur Wärmeübertragung mit einer geschlossenen Kanalstruktur, in der ein Wärmetransportmedium angeordnet ist, das entlang der Kanalstruktur durch die Oberflächenspannung des Wärmetransportmediums abwechselnd Dampfsegmente und Flüssigsegmente bildet. Diese Dampf- und Flüssigsegmente werden durch einen Temperaturgradienten zum Pulsieren beziehungsweise Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation des gasförmigen Wärmetransportmediums und geben dabei latente Wärme ab. Die lokalen Temperatur- und Druckunterschiede treiben das ständige Pulsieren beziehungsweise Oszillieren der Dampf- und Flüssigsegmente an.

Die Offenlegungsschrift EP 3 823 018 A1 beschreibt ein Elektronikmodul. Das Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Vor diesem Hintergrund liegt der Erfindung die Aufgabe zugrunde, ein Elektronikmodul anzugeben, welches, im Vergleich zum Stand der Technik, kostengünstiger ist.

Diese Aufgabe wird erfindungsgemäß gelöst durch ein Elektronikmodul, umfassend eine pulsierende Heatpipe mit einer Kanalstruktur, in der ein Wärmetransportmedium angeordnet ist, und zumindest ein elektronisches Bauelement, das mit dem Wärmetransportmedium in einer thermisch leitfähigen Verbindung steht, wobei die pulsierende Heatpipe wenigstens einen Grundkörper aufweist, in welchem die Kanalstruktur zumindest teilweise ausgebildet ist, wobei der Grundkörper aus einem dielektrischen Werkstoff hergestellt und zumindest teilweise fluiddicht beschichtet ist, wobei das zumindest ein elektronisches Bauelement über die pulsierende Heatpipe mit einer metallischen Wärmesenke elektrisch isolierend und thermisch leitend verbunden ist.

Ferner wird die Aufgabe erfindungsgemäß gelöst durch einen Stromrichter mit mindestens einem derartigen Elektronikmodul.

Darüber hinaus wird die Aufgabe erfindungsgemäß gelöst durch ein Verfahren zur Herstellung eines Elektronikmoduls, umfassend eine pulsierende Heatpipe mit einer Kanalstruktur, in der ein Wärmetransportmedium angeordnet wird, und zumindest ein elektronisches Bauelement, das mit dem Wärmetransportmedium in einer thermisch leitfähigen Verbindung steht, wobei die pulsierende Heatpipe wenigstens einen Grundkörper aufweist, in welchem die Kanalstruktur zumindest teilweise ausgebildet wird, wobei der Grundkörper aus einem dielektrischen Werkstoff hergestellt und zumindest teilweise fluiddicht beschichtet wird, wobei das zumindest ein elektronisches Bauelement über die pulsierende Heatpipe mit einer metallischen Wärmesenke elektrisch isolierend und thermisch leitend verbunden wird.

Die in Bezug auf das Elektronikmodul nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Kosten für eine pulsierende Heatpipe für ein Elektronikmodul durch die Verwendung von dielektrischen Werkstoffen für die Heatpipe zu senken, da für den Wärmetransport ausgehend von einem elektronischen Bauelement, das als Wärmequelle fungiert, hin zu einer metallischen Wärmesenke mittels einer oszillierenden Heatpipe kein metallischer Werkstoff erforderlich ist und durch den Verzicht auf metallische Werkstoffe erheblich Kosten gesenkt werden. Beispielsweise können Polymere, z.B. Polypropylen, um den Faktor 10 günstiger als Aluminium und um den Faktor 50 günstiger als Kupfer sein.

Eine derartige pulsierende Heatpipe weist eine Kanalstruktur auf, in der ein Wärmetransportmedium angeordnet ist, wobei das elektronische Bauelement mit dem Wärmetransportmedium in einer thermisch leitfähigen Verbindung steht. Ein derartiges elektronisches Bauelement kann unter anderem ein Transistor, z.B. ein Insulated-Gate-Bipolar-Transistor (IGBT) oder ein Feldeffekttransistor, ein Triac, ein Thyristor, eine Diode oder ein passives Bauelement wie ein Kondensator oder ein Widerstand, insbesondere ein Shunt-Widerstand, sein. Eine Einkopplung in die pulsierende Heatpipe kann beispielsweise über eine Metallisierung, auf der das elektronische Bauelement kontaktiert ist, erfolgen. Eine derartige Metallisierung, welche beispielsweise Kupfer, Aluminium, Gold und/oder Silber enthält, weist eine gute Wärmeleitfähigkeit auf. Die metallische Wärmesenke kann unter anderem als Kühlkörper ausgeführt sein, welcher aus einer Legierung, die Aluminium und/oder Kupfer enthält, hergestellt ist und Rippen zur Vergrößerung der Oberfläche umfassen kann.

Die pulsierende Heatpipe weist wenigstens einen Grundkörper aus einem dielektrischen Werkstoff, insbesondere aus einem Polymer, auf, in welchem die Kanalstruktur zumindest teilweise ausgebildet ist. Ein derartiger dielektrischer Werkstoff kann jedoch für das Wärmetransportmedium, das in der pulsierenden Heatpipe Dampf- und Flüssigsegmente ausbildet, durchlässig sein, sodass sich das Wärmetransportmediums durch den dielektrischen Werkstoff des Grundkörpers verflüchtigen kann. Um ein Verflüchtigen des Wärmetransportmediums zu verhindern, wird der Grundkörper zumindest teilweise fluiddicht beschichtet. Somit kann im Bereich des Grundkörpers auf kostenintensive metallische Werkstoffe ohne merkliche Beeinflussung der Heatpipe verzichtet werden.

Eine weitere Ausführungsform sieht vor, dass das zumindest eine elektronische Bauelement über den zumindest teilweise fluiddicht beschichteten Grundkörper elektrisch isoliert von einer metallischen Wärmesenke angeordnet ist. Der aus einem dielektrischen Werkstoff hergestellte Grundkörper ermöglicht eine elektrische Isolation des elektronischen Bauelements von der metallischen Wärmesenke. Durch den Einsatz einer elektrisch isolierenden Flüssigkeit für die 2-Phasen-Kühlung kann eine zusätzliche bzw. verbesserte elektrische Trennung erreicht werden. Insbesondere bei einem Elektronikmodul mit vertikalen Leistungshalbleitern, wie z.B. IGBTs, kann auf eine dedizierte Isolationsschicht, welche üblicherweise durch ein DCB-Substrat bereitgestellt wird, verzichtet werden, was zusätzlich Kosten einspart.

Eine weitere Ausführungsform sieht vor, dass der Grundkörper mit einem elektrisch isolierenden Werkstoff zumindest teilweise fluiddicht beschichtet ist. Ein derartiger elektrisch isolierender Werkstoff kann mittels eines CVD-Verfahrens (Chemical Vapor Deposition, chemische Gasphasenabscheidung) oder mittels eines PVD-Verfahrens (Physical Vapor Deposition, physikalische Gasphasenabscheidung) aufgebracht werden. Durch eine derartige Beschichtung wird sowohl ein Verflüchtigen des Wärmetransportmediums verhindert als auch eine flexiblere Ausgestaltung der pulsierenden Heatpipe für eine elektrische Trennung zwischen dem zumindest einen elektronischen Bauelement und der metallischen Wärmesenke ermöglicht.

Eine weitere Ausführungsform sieht vor, dass der elektrisch isolierende Werkstoff einen keramischen Werkstoff und/oder einen glasartigen Werkstoff enthält. Keramische und glasartige Werkstoffe weisen gute Isolationseigenschaften auf und ermöglichen auch bei sehr geringen Schichtdicken im Bereich von 5-50 µm eine ausreichende Dichtigkeit. Insbesondere ein glasartiger Werkstoff, beispielsweise Siliziumdioxid, kann mittels eines CVD-Verfahrens, insbesondere mittels eines PACVD-Verfahrens (plasma-enhanced chemical vapour deposition, plasmaunterstützte chemische Gasphasenabscheidung) auf einen thermisch stabilen Kunststoff aufgebracht werden, da ein derartiges Verfahren typischerweise bei 200°C bis 500°C stattfinden kann und so der Kunststoff nicht zerstört wird.

Eine weitere Ausführungsform sieht vor, dass der Grundkörper mit einem metallischen Werkstoff zumindest teilweise fluiddicht beschichtet ist. Der metallische Werkstoff, z.B. Kupfer, Gold, Silber, kann unter anderem durch Heißprägen, ein PVD-Verfahren, insbesondere Sputtern, oder galvanisch aufgebracht werden. Derartige Verfahren sind einfach und kostengünstig. Durch Metallisierungsdicken im Bereich von 5-50 µm wird ein Verflüchtigen des Wärmetransportmediums effektiv verhindert.

Eine weitere Ausführungsform sieht vor, dass die Kanalstruktur durch eine fluiddichte Beschichtung diffusionsdicht gekapselt ist. Beispielsweise sind die Kanäle der Kanalstruktur beschichtet, um ein Verflüchtigen des Wärmetransportmediums zu verhindern. Eine derartige Beschichtung in den Kanälen ist nach der Herstellung des aus einem dielektrischen Werkstoff hergestellten Grundkörpers einfach und kostengünstig aufbringbar.

Eine weitere Ausführungsform sieht vor, dass die fluiddichte Beschichtung zumindest teilweise direkt mit dem Wärmetransportmedium in Kontakt steht. Insbesondere bei Verwendung eines metallischen Werkstoffs zur Beschichtung wird ein verbesserter Wärmeübergang erreicht.

Eine weitere Ausführungsform sieht vor, dass die Kanalstruktur vollständig im Grundkörper ausgebildet ist. Eine derartige Heatpipe ist einfach und kostengünstig herstellbar.

Eine weitere Ausführungsform sieht vor, dass durch die fluiddichte Beschichtung eine geschlossene Querschnittskontur der Kanalstruktur hergestellt wird. Durch eine derartige geschlossene Querschnittskontur wird ein Verflüchtigen des Wärmetransportmediums kostengünstig und effektiv verhindert. Eine weitere Ausführungsform sieht vor, dass sich die Kanalstruktur in die metallische Wärmesenke und/oder in ein elektrisch leitfähiges Kontaktelement, auf welchem das elektronische Bauelement kontaktiert ist, erstreckt. Durch eine derartige Anordnung wird eine verbesserter Wärmeübergang vom elektrisch leitfähigen Kontaktelement und/oder an die metallische Wärmesenke erreicht. Ferner wird Bauraum eingespart.

Eine weitere Ausführungsform sieht vor, dass der Grundkörper stoffschlüssig mit der metallischen Wärmesenke verbunden ist, wobei die Kanalstruktur im Bereich des Grundkörpers durch die fluiddichte Beschichtung diffusionsdicht gekapselt ist. Eine stoffschlüssige Verbindung ist unter anderem durch Kleben, Löten oder Sintern herstellbar. Da die metallische Wärmesenke bereits ein Entweichen des Wärmetransportmediums verhindert, ist die Beschichtung nur im Bereich des Grundkörpers erforderlich. Durch eine derartige Anordnung wird ein verbesserter Wärmeübergang erreicht und Bauraum eingespart.

Eine weitere Ausführungsform sieht vor, dass sich die fluiddichte Beschichtung zumindest teilweise über die metallische Wärmesenke erstreckt. Durch einen derartigen Übergang wird die Dichtigkeit im Verbindungsbereich der Heatpipe zur metallischen Wärmesenke verbessert.

Im Folgenden wird die Erfindung anhand der in den Figuren dargestellten Ausführungsbeispiele näher beschrieben und erläutert.

### Es zeigen:

- FIG 1: eine schematische Darstellung einer ersten Ausführungsform eines Elektronikmoduls in einer Querschnittsdarstellung,
- FIG 2: eine schematische Darstellung einer zweiten Ausführungsform eines Elektronikmoduls in einer Querschnittsdarstellung,
- FIG 3: eine schematische Darstellung einer dritten Ausführungsform eines Elektronikmoduls in einer Querschnittsdarstellung,
- FIG 4: eine schematische Darstellung einer vierten Ausführungsform eines Elektronikmoduls in einer Querschnittsdarstellung,
- FIG 5: eine schematische Darstellung einer fünften Ausführungsform eines Elektronikmoduls in einer Querschnittsdarstellung,
- FIG 6: eine schematische Darstellung einer sechsten Ausführungsform eines Elektronikmoduls in einer Querschnittsdarstellung,
- FIG 7: eine schematische Darstellung einer siebten Ausführungsform eines Elektronikmoduls in einer Querschnittsdarstellung,
- FIG 8: eine schematische Darstellung einer achten Ausführungsform eines Elektronikmoduls in einer Querschnittsdarstellung und
- FIG 9: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

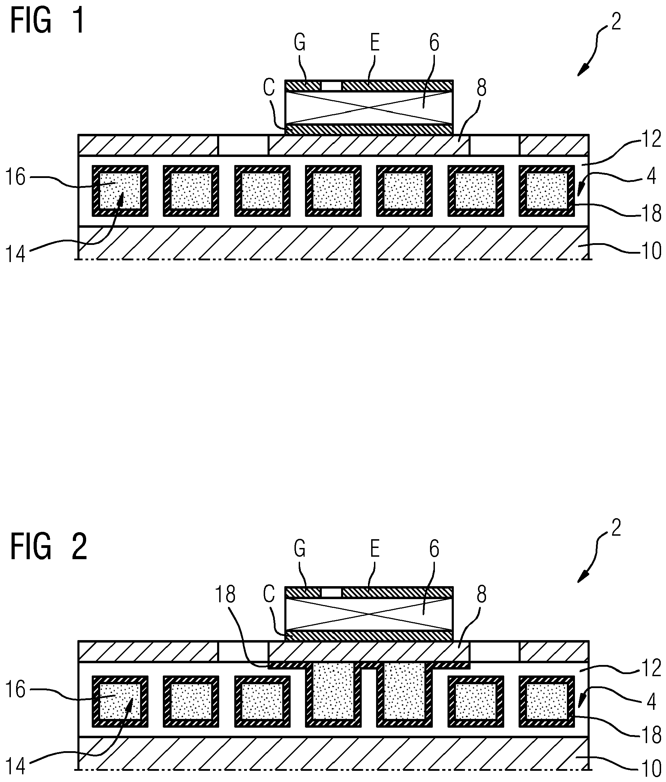

FIG 1 zeigt eine schematische Darstellung einer ersten Ausführungsform eines Elektronikmoduls 2 in einer Querschnittsdarstellung, welches eine pulsierende Heatpipe 4 und ein elektronisches Bauelement 6 umfasst. Beispielhaft ist das elektronische Bauelement 6 als ein Insulated-Gate-Bipolar-Transistor (IGBT) ausgeführt. Weitere Beispiele für derartige elektronische Bauelemente 6 sind andere Transistortypen wie Feldeffekttransistoren, Triacs, Thyristoren, Dioden sowie passive Bauelemente wie Kondensatoren oder Widerstände, insbesondere Shunt-Widerstände. Der IGBT umfasst einen Steueranschluss, welcher als Gate-Anschluss G ausgeführt ist, sowie Lastanschlüsse, welche als Kollektor-Anschluss C und Emitter-Anschluss E ausgeführt sind. Der IGBT ist kollektorseitig auf einem elektrisch leitfähigen Kontaktelement 8 kontaktiert, welches als Metallisierung ausgeführt ist, die beispielsweise Kupfer enthält. Insbesondere ist der IGBT stoffschlüssig, beispielsweise durch eine Lötverbindung oder durch eine Sinterverbindung, mit der Metallisierung verbunden.

Das elektronische Bauelement 6 fungiert als Wärmequelle, wobei ein Wärmetransport ausgehend von der Wärmequelle über die pulsierende Heatpipe 4 hin zu einer Wärmesenke 10 stattfindet. Der Wärmeeintrag erfolgt über das elektrisch leitfähige Kontaktelement 8. Die Wärmesenke 10 ist beispielhaft als metallischer Kühlkörper ausgeführt, welcher einen Übergang zu einem Kühlfluid herstellt. Ein Kühlfluid kann unter anderem Luft oder Wasser sein. Der Kühlkörper kann beispielsweise Kühllamellen aufweisen, welche einen Übergang zu einer Kühlfluidströmung herstellen.

Die pulsierende Heatpipe 4 weist einen Grundkörper 12 auf, in der eine planare Kanalstruktur 14 ausgebildet ist, welche einen mäanderartig verlaufenden geschlossenen Kanal umfasst. In FIG 1 ist die Kanalstruktur 14 vollständig im Grundkörper 12 ausgebildet. Innerhalb der Kanalstruktur 14 ist ein Wärmetransportmedium 16 angeordnet. Das Wärmetransportmedium 16 bildet entlang des mäanderartig verlaufenden geschlossenen Kanals abwechselnd Dampfsegmente, in denen das Wärmetransportmedium 16 in einer gasförmigen Phase vorliegt, und Flüssigsegmente, in denen das Wärmetransportmedium 16 in einer gasförmigen Phase vorliegt. Die Dampfsegmente und Flüssigsegmente werden in dem Kanal durch Temperaturgradienten zu pulsierenden beziehungsweise oszillierenden Bewegungen angeregt. Beispielsweise ist das Wärmetransportmedium 16 Perfluor-N-alkyl-morpholin, das sich aufgrund seiner hohen Wärmeleitfähigkeit, seines Siedepunkts und seiner dielektrischen Eigenschaften gut als Wärmetransportmedium 16 eines Elektronikmoduls 2 eignet.

Der Grundkörper 12 der pulsierenden Heatpipe 4 ist aus einem dielektrischen Werkstoff hergestellt, wobei das elektronische Bauelement 6 über den dielektrischen Werkstoff des Grundkörpers 12 elektrisch isoliert von der metallischen Wärmesenke 10 angeordnet ist. Insbesondere bei Verwendung eines elektrisch isolierenden Wärmetransportmediums 16 wird eine elektrische Trennung erreicht. Der dielektrische Werkstoff kann unter anderem ein Polymer, z.B. Polypropylen, enthalten. Derartige Polymere weisen können gasdurchlässig sein. Eine fluiddichte Beschichtung 18 der Kanalstruktur 14 verhindert ein Verflüchtigen des Wärmetransportmediums 16 durch den dielektrischen Werkstoff des Grundkörpers 12, wobei die Kanäle der Kanalstruktur 14 in der Ausführungsform von FIG 1 fluiddicht beschichtet sind und die fluiddichte Beschichtung 18 direkt mit dem Wärmetransportmedium 16 in Kontakt steht und durch die fluiddichte Beschichtung 18 eine geschlossene Querschnittskontur der Kanalstruktur 14 hergestellt wird. Durch die geschlossene Querschnittskontur wird eine Gasdichtigkeit der Kanalstruktur 14 erreicht. Beispielsweise wird der Grundkörper 12 mittels Druckguss hergestellt und in einem darauffolgenden Schritt die fluiddichte Beschichtung 18 in der Kanalstruktur 14 aufgebracht.

Die fluiddichte Beschichtung 18 kann unter anderem einen elektrisch isolierenden Werkstoff, insbesondere einen keramischen und/oder glasartigen Werkstoff, umfassen. Insbesondere eine glasartige Beschichtung kann beispielsweise über CVD (chemical vapor deposition), PVD (physical vapor deposition), Sol-Gel-Prozesse oder aus einer Schmelze heraus aufgebracht werden. Die fluiddichte Beschichtung 18 kann vollständig aus einem elektrisch isolierenden, insbesondere aus einem keramischen und/oder glasartigen Werkstoff, hergestellt sein. Durch eine derartige keramische und/oder glasartigen Beschichtung kann ein aus einem Polymer hergestellter Grundkörper 12 hermetisch geschlossen werden, ohne eine elektrisch leitfähige Verbindung herzustellen.

Zusätzlich oder alternativ kann die fluiddichte Beschichtung 18 einen elektrisch leitfähigen, insbesondere metallischen, Werkstoff aufweisen. Ein metallischer Werkstoff kann unter anderem durch thermisches Metallsprühen, insbesondere durch Kaltgasspritzen, Plasmasprühen, PVD, Heißpressen, oder mittels Galvanik aufgebracht werden. Typische Schichtdicken des metallischen Werkstoffs liegen beispielsweise im Bereich von 10 µm bis 50 µm. Beim Aufbringen einer metallischen fluiddichten Beschichtung 18 mittels Galvanik ist es unter Umständen vorteilhaft, wenn bei dem zuvor genannten Polymer des Grundkörpers 12 eine Schicht eines Katalysators, beispielsweise Palladium, zumindest im Bereich der fluiddichten Beschichtung 18, vorgesehen ist. Dieser ermöglicht ein direktes Anwachsen des Metalls an das Polymer des Grundkörpers 12. Beispielsweise wird ein Polymer wie ABS oder PA mit einem metallischen Werkstoff beschichtet, wobei der metallische Werkstoff durch chemische Behandlung des Polymers, katalytische Aktivierung und nachfolgender galvanischer Metallisierung, z.B. mit Kupfer, Nickel und/oder Chrom, aufgebracht wird. Die fluiddichte Beschichtung 18 kann vollständig aus einem elektrisch leitfähigen, insbesondere aus einem metallischen, Werkstoff hergestellt sein.

FIG 2 zeigt eine schematische Darstellung einer zweiten Ausführungsform eines Elektronikmoduls 2 in einer Querschnittsdarstellung, wobei das elektronische Bauelement 6 mit dem Wärmetransportmedium 16 direkt in Kontakt steht. Die Kanalstruktur 14 erstreckt sich durch das elektrisch leitfähige Kontaktelement 8, wobei sich die, insbesondere metallische, fluiddichte Beschichtung 18 zumindest teilweise mit dem elektrisch leitfähigen Kontaktelement 8 überlappen kann. Die weitere Ausgestaltung des Elektronikmoduls 2 in FIG 2 entspricht der in FIG 1.

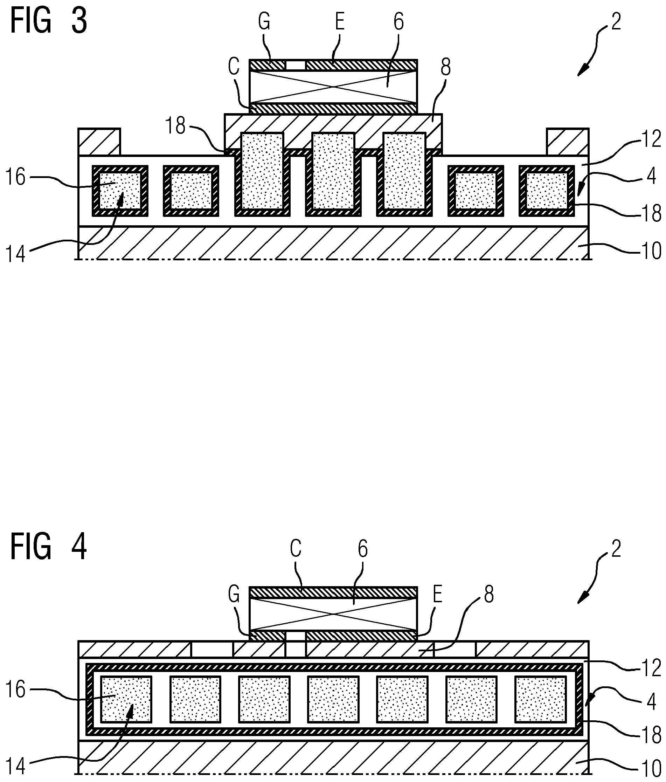

FIG 3 zeigt eine schematische Darstellung einer dritten Ausführungsform eines Elektronikmoduls 2 in einer Querschnittsdarstellung, wobei das elektrisch leitfähige Kontaktelement 8, auf welchem das elektronisches Bauelement 6 kontaktiert ist, direkt mit dem Wärmetransportmedium 16 in Kontakt steht. Die Kanalstruktur 14 erstreckt sich teilweise durch das elektrisch leitfähige Kontaktelement 8, wobei sich die, insbesondere metallische, fluiddichte Beschichtung 18 zumindest teilweise mit dem elektrisch leitfähigen Kontaktelement 8 überlappen kann. Die weitere Ausgestaltung des Elektronikmoduls 2 in FIG 3 entspricht der in FIG 1.

FIG 4 zeigt eine schematische Darstellung einer vierten Ausführungsform eines Elektronikmoduls 2 in einer Querschnittsdarstellung, wobei das beispielhaft als IGBT ausgeführte elektronische Bauelement 6 über den Gate-Anschluss G und den Emitter-Anschluss E stoffschlüssig mit der Metallisierung, welche strukturiert ausgeführt ist, verbunden ist. Die fluiddichte Beschichtung 18 ist vollständig innerhalb des Grundkörpers 12 verlaufend angeordnet, wobei die Kanalstruktur 14 als Ganzes von der fluiddichten Beschichtung 18 umgeben ist.

Durch die geschlossene Querschnittskontur der fluiddichten Beschichtung 18 wird eine Gasdichtigkeit der Kanalstruktur 14 erreicht. Die innerhalb des Grundkörpers 12 geführte fluiddichten Beschichtung 18 weist einen verbesserten Schutz, beispielsweise vor Abrieb und Korrosion, auf. Beispielsweise wird der Grundkörper 12 mittels Druckguss hergestellt und in einem weiteren Schritt die fluiddichte Beschichtung 18 auf der Außenseite aufgebracht. In einem darauffolgenden Schritt werden die beschichteten Flächen, z.B. mit dem Kunststoff, insbesondere Polymer, des Grundkörpers 12 überspritzt. Zusätzlich oder alternativ können die Außenflächen mit einer Lackschicht gecoatet werden. Die weitere Ausgestaltung des Elektronikmoduls 2 in FIG 4 entspricht der in FIG 1.

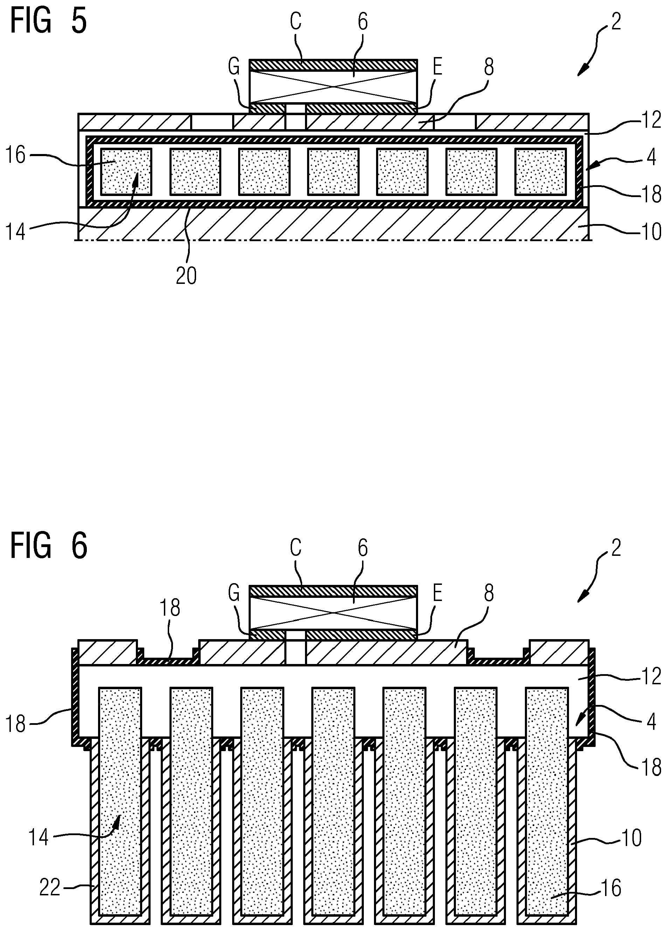

FIG 5 zeigt eine schematische Darstellung einer fünften Ausführungsform eines Elektronikmoduls 2 in einer Querschnittsdarstellung, wobei die fluiddichte Beschichtung 18 auf einer Außenfläche 20 des Grundkörpers 12 verlaufend angeordnet ist.

Die fluiddicht beschichtete Außenfläche 20 des Grundkörpers 12 ist, insbesondere stoffschlüssig, mit der Wärmesenke 10 verbunden. Beispielsweise ist die fluiddichte Beschichtung 18 aus einem metallischen Werkstoff hergestellt, wobei die stoffschlüssige Verbindung mit der Wärmesenke 10 durch Löten oder Sintern herstellbar ist. Die weitere Ausgestaltung des Elektronikmoduls 2 in FIG 5 entspricht der in FIG 4.

FIG 6 zeigt eine schematische Darstellung einer sechsten Ausführungsform eines Elektronikmoduls 2 in einer Querschnittsdarstellung. Die Kanalstruktur 14 erstreckt sich teilweise durch die Wärmesenke 10, welche metallische Rippen 22, auch Finnen genannt, ausbildet. Die metallischen Rippen 22 sind beispielsweise aus einer Legierung hergestellt, welche Aluminium und/oder Kupfer enthält, und dienen zur Vergrößerung der Oberfläche, um die Wärmeübertragung an die Umgebung und damit die Entwärmung zu verbessern. Der Grundkörper 12 ist stoffschlüssig, z.B. durch Kleben, mit den Rippen 22 verbunden. Eine fluiddichte Beschichtung 18 des Grundkörper 12 verhindert ein Verflüchtigen des Wärmetransportmediums 16. Die fluiddichte Beschichtung 18 ist vollständig aus einem elektrisch isolierenden, insbesondere aus einem keramischen und/oder glasartigen Werkstoff, hergestellt. Beispielsweise wird eine glasartige Beschichtung über CVD (chemical vapor deposition) oder PVD (physical vapor deposition) aufgetragen, nachdem der Grundkörper 12 mit den Rippen 22 verbunden wurde. Die elektrisch isolierend ausgeführte fluiddichte Beschichtung 18 erstreckt sich teilweise über das elektrisch leitfähige Kontaktelement 8 und die Rippen 22 der Wärmesenke 10. Das elektronische Bauelement 6 ist über den Grundkörper 12 und die elektrisch isolierende fluiddichte Beschichtung 18 der pulsierenden Heatpipe 4 mit der metallischen Wärmesenke 10 elektrisch isolierend und thermisch leitend verbunden. Die weitere Ausgestaltung des Elektronikmoduls 2 in FIG 6 entspricht der in FIG 1.

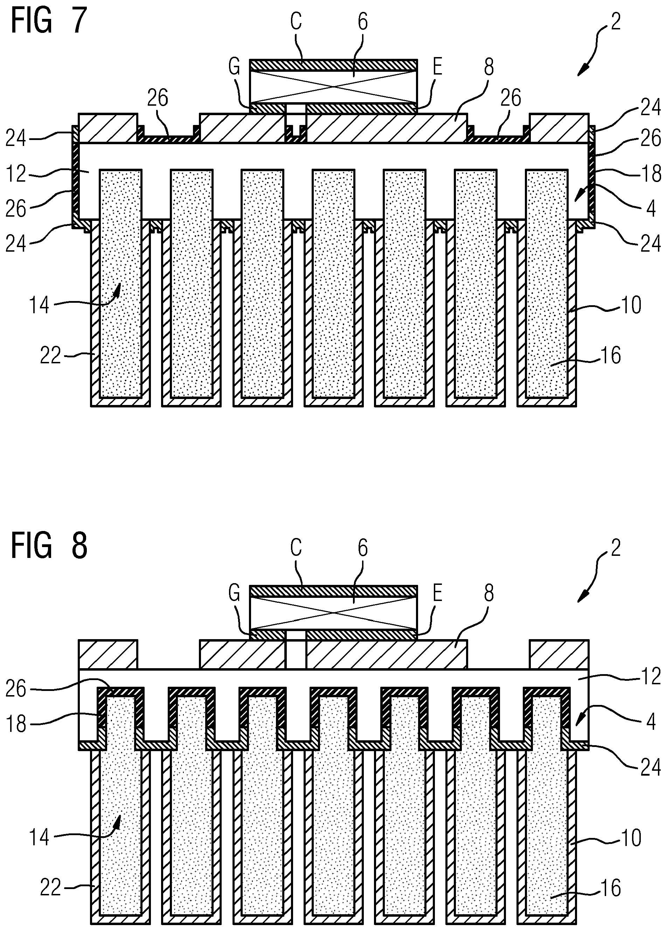

FIG 7 zeigt eine schematische Darstellung einer siebten Ausführungsform eines Elektronikmoduls 2 in einer Querschnittsdarstellung. Die fluiddichte Beschichtung 18 umfasst elektrisch leitfähige, insbesondere metallische, Abschnitte 24 und zumindest einen elektrisch isolierenden Abschnitt 26, sodass das elektronische Bauelement 6 über den Grundkörper 12 und den elektrisch isolierenden Abschnitt 26 der fluiddichten Beschichtung 18 der pulsierenden Heatpipe 4 mit der metallischen Wärmesenke 10 elektrisch isolierend und thermisch leitend verbunden ist. Die weitere Ausgestaltung des Elektronikmoduls 2 in FIG 7 entspricht der in FIG 6.

FIG 8 zeigt eine schematische Darstellung einer achten Ausführungsform eines Elektronikmoduls 2 in einer Querschnittsdarstellung. Die fluiddichte Beschichtung 18 ist innerhalb der Kanalstruktur 14 angeordnet und steht direkt mit dem Wärmetransportmedium 16 in Kontakt. Die fluiddichte Beschichtung 18 kann einen elektrisch leitfähigen, insbesondere metallischen, Abschnitt 24 und einen elektrisch isolierenden Abschnitt 26 aufweisen. Das elektronische Bauelement 6 ist über den Grundkörper 12 der pulsierenden Heatpipe 4 mit der metallischen Wärmesenke 10 elektrisch isolierend und thermisch leitend verbunden. Ein elektrisch isolierender Abschnitt 26 kann, insbesondere bei Verwendung eines elektrisch isolierenden Wärmetransportmediums 16, die Isolation verbessern. Ferner wird eine Verlängerung von Luft- und Kriechstrecken ermöglicht. Über einen metallischen Abschnitt 24 sind die Rippen, z.B. durch Löten oder Sintern mit dem Grundkörper verbindbar. Beispielsweise wird die fluiddichte Beschichtung 18 aufgetragen, wobei der Grundkörper 12 in einem darauffolgenden Schritt mit den Rippen 22 verbunden wird. Die weitere Ausgestaltung des Elektronikmoduls 2 in FIG 8 entspricht der in FIG 7.

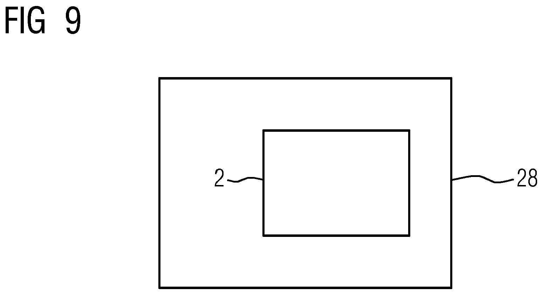

FIG 9 zeigt eine schematische Darstellung eines Stromrichters 28, welcher beispielhaft ein Elektronikmoduls 2 umfasst.

Zusammenfassend betrifft die Erfindung ein Elektronikmodul 2, umfassend eine pulsierende Heatpipe 4 mit einer Kanalstruktur 14, in der ein Wärmetransportmedium 16 angeordnet ist, und zumindest ein elektronisches Bauelement 6, das mit dem Wärmetransportmedium 16 in einer thermisch leitfähigen Verbindung steht. Um, im Vergleich zum Stand der Technik, eine bessere Kostenposition zu erreichen, wird vorgeschlagen, dass die pulsierende Heatpipe 4 wenigstens einen Grundkörper 12 aufweist, in welchem die Kanalstruktur 14 zumindest teilweise ausgebildet ist, wobei der Grundkörper 12 aus einem dielektrischen Werkstoff hergestellt und zumindest teilweise fluiddicht beschichtet ist, wobei das zumindest ein elektronisches Bauelement 6 über die pulsierende Heatpipe 4 mit einer metallischen Wärmesenke 10 elektrisch isolierend und thermisch leitend verbunden ist.

## Patentansprüche

1. Elektronikmodul (2), umfassend eine pulsierende Heatpipe (4) mit einer Kanalstruktur (14), in der ein Wärmetransportmedium (16) angeordnet ist, und zumindest ein elektronisches Bauelement (6), das mit dem Wärmetransportmedium (16) in einer thermisch leitfähigen Verbindung steht,
wobei die pulsierende Heatpipe (4) wenigstens einen Grundkörper (12) aufweist, in welchem die Kanalstruktur (14) zumindest teilweise ausgebildet ist,
wobei der Grundkörper (12) aus einem dielektrischen Werkstoff hergestellt und zumindest teilweise fluiddicht beschichtet ist,
wobei das zumindest ein elektronisches Bauelement (6) über die pulsierende Heatpipe (4) mit einer metallischen Wärmesenke (10) elektrisch isolierend und thermisch leitend verbunden ist.

2. Elektronikmodul (2) nach Anspruch 1,
wobei das zumindest eine elektronisches Bauelement (6) über den zumindest teilweise fluiddicht beschichteten Grundkörper (12) elektrisch isoliert von einer metallischen Wärmesenke (10) angeordnet ist.

3. Elektronikmodul (2) nach einem der Ansprüche loder 2, wobei der Grundkörper (12) mit einem elektrisch isolierenden Werkstoff zumindest teilweise fluiddicht beschichtet ist.

4. Elektronikmodul (2) nach Anspruch 3,
wobei der elektrisch isolierende Werkstoff einen keramischen Werkstoff und/oder einen glasartigen Werkstoff enthält.

5. Elektronikmodul (2) nach einem der Ansprüche 1 bis 4, wobei der Grundkörper (12) mit einem metallischen Werkstoff zumindest teilweise fluiddicht beschichtet ist.

6. Elektronikmodul (2) nach einem der vorherigen Ansprüche, wobei die Kanalstruktur (14) durch eine fluiddichte Beschichtung (18) diffusionsdicht gekapselt ist.

7. Elektronikmodul (2) nach Anspruch 6,
wobei die fluiddichte Beschichtung (18) zumindest teilweise direkt mit dem Wärmetransportmedium (16) in Kontakt steht.

8. Elektronikmodul (2) nach einem der Ansprüche 6 oder 7, wobei die Kanalstruktur vollständig im Grundkörper (12) ausgebildet ist.

9. Elektronikmodul (2) nach Anspruch 8,
wobei durch die fluiddichte Beschichtung (18) eine geschlossene Querschnittskontur der Kanalstruktur (14) hergestellt wird.

10. Elektronikmodul (2) nach einem der Ansprüche 1 bis 5, wobei sich die Kanalstruktur in die metallische Wärmesenke (10) und/oder in ein elektrisch leitfähiges Kontaktelement (8), auf welchem das elektronische Bauelement (6) kontaktiert ist, erstreckt.

11. Elektronikmodul (2) nach Anspruch 10,
wobei der Grundkörper (12) stoffschlüssig mit der metallischen Wärmesenke (10) verbunden ist,
wobei die Kanalstruktur (14) im Bereich des Grundkörpers (12) durch die fluiddichte Beschichtung (18) diffusionsdicht gekapselt ist.

12. Elektronikmodul (2) nach Anspruch 11,
wobei sich die fluiddichte Beschichtung (18) zumindest teilweise über die metallische Wärmesenke (10) erstreckt.

13. Stromrichter (28) mit mindestens einem Elektronikmodul (2) nach einem der vorherigen Ansprüche.

14. Verfahren zur Herstellung eines Elektronikmoduls (2), umfassend eine pulsierende Heatpipe (4) mit einer Kanalstruktur (14), in der ein Wärmetransportmedium (16) angeordnet wird, und zumindest ein elektronisches Bauelement (6), das mit dem Wärmetransportmedium (16) in einer thermisch leitfähigen Verbindung steht,
wobei die pulsierende Heatpipe (4) wenigstens einen Grundkörper (12) aufweist, in welchem die Kanalstruktur (14) zumindest teilweise ausgebildet wird,
wobei der Grundkörper (12) aus einem dielektrischen Werkstoff hergestellt und zumindest teilweise fluiddicht beschichtet wird,
wobei das zumindest ein elektronisches Bauelement (6) über die pulsierende Heatpipe (4) mit einer metallischen Wärmesenke (10) elektrisch isolierend und thermisch leitend verbunden wird.

15. Verfahren nach Anspruch 14,
wobei der Grundkörper (12) mit einem elektrisch isolierenden Werkstoff und/oder mit einem metallischen Werkstoff beschichtet wird.
